# EUROPEAN PATENT SPECIFICATION

(11) **EP 0 506 020 B1**
(45) Date of publication and mention of the grant of the patent: **10.09.1997**
(21) Application number: 92105147.0
(22) Date of filing: 25.03.1992
(51) Int. Cl.: C30B 31/20, H01L 21/26

(54) **Process for producing a neutron transmutation doped Czochralski-grown silicon single crystal**
Verfahren zur Herstellung eines neutronenumwandlungsdotierten Czochralski-Silizium-Einkristalls
Procédé pour la production d'un monocristal de silicium obtenu selon le procédé Czochralski et dopé par transmutation sous irradiation neutronique

(30) Priority: 26.03.1991 JP 87441/91
(43) Date of publication of application: 30.09.1992
(73) Proprietor: SHIN-ETSU HANDOTAI COMPANY LIMITED, Chiyoda-ku Tokyo (JP)
(72) Inventor: Toda, Masato, Annaka-shi, Gunma-ken (JP); Takenaka, Takao, Annaka-shi, Gunma-ken (JP); Kitagawara, Yutaka, Takasaki-shi, Gunma-ken (JP)
(74) Representative: Grünecker, Kinkeldey, Stockmair & Schwanhäusser Anwaltssozietät

(56) References cited:
- DE-A- 2 364 015
- DE-A- 3 714 357
- GB-A- 2 183 092
- PESC 88 RECORD, 19TH ANNUAL IEEE POWER ELECTRONICS SPECIALISTS CONFERENCE 11 April 1988, KYOTO,JP pages 1339 - 1345; TAKUSU ET AL: 'NEUTRON TRANSMUTED MAGNETIC CZOCHRALSKI GROWN SILICON WAFER FOR POWER DEVICE'
- EXTENDED ABSTRACTS. vol. 80, no. 2, October 1980, PRINCETON, NEW JERSEY US pages 1094 - 1096; CLELAND ET AL: 'ANNEALING STUDIES OF CZOCHRALSKI GROWN NEUTRON TRANSMUTATION DOPED SILICON'
- SOVIET PHYSICS SEMICONDUCTORS. vol. 24, no. 11, November 1990, NEW YORK US pages 1227 - 1229; KARUMIDZE: 'INFLUENCE OF NEUTRON IRRADIATION TEMPERATURE ON THE FORMATION OF STRUCTURE DEFECTS IN SILICON GROWN BY THE CZOCHRALSKI METHOD'

## Description

The present invention relates to a method for producing a neutron transmutation doped silicon single crystal grown by the Czochralski method.

Neutron transmutation doping (hereinafter referred to, for brevity, as "NTD") is employed in order to obtain impurity homogeneity or resistivity homogeneity in semiconductor silicon single crystals. Conventionally, the silicon single crystal used for the NTD is substantially limited to silicon single crystals grown by the floating-zone (FZ) method. However, in recent years, silicon single crystals grown by the Czochralski (CZ) method (hereinafter referred to as "CZ silicon single crystals") have also been used for the NTD. After neutron irradiation in the NTD, silicon single crystals have a large number of lattice defects due to radiation damage. The irradiated silicon single crystals, therefore, must be annealed in order to annihilate the defects and to restore the crystal qualities (electric and other physical characteristics) to that expected from the condition before neutron irradiation in the NTD.

The annealing applied to annihilate the crystal defects due to radiation damage is generally known and used as far as FZ silicon single crystals are concerned. In the case of CZ silicon single crystals, however, the annealing after irradiation brings about some reductions in their lifetime values from the ones before neutron irradiation in the NTD. In addition, it was found that the longer the annealing time (i.e., the restorative heat treatment time), the shorter the lifetime. The reduction of lifetime caused by the annealing after irradiation must be prevented because the lifetime has a strong influence on the performance of semiconductor devices fabricated on the silicon wafers.

Methods to produce n-doped Czochralski grown silicon single crystals by neutron-transmutation-doping and a subsequent heat treatment are, for example, described in GB-A-2 183 092 and PESC '88 Record, Vol. 2, 19th Annual IEEE Power Electronics Specialists Conference, 11/04/88, Kyoto, JP; S. Takasu et al.; "Neutron Transmuted MCZ-Grown Silicon Wafer For Power Device", pp. 1339-45. Further examples are given in DE-A-3714357 and Extended Abstracts, Vol. 80, No. 2, October 1980, Princeton, New Jersey, USA, J. W. Cleland et al.; "Annealing Studies of CZ-Grown Neutron-Transmutation-Doped Silicon", pp. 1064-96.

With the foregoing difficulties of the prior art in view, it is an object of the present invention to provide a process for producing CZ silicon single crystal for NTD, which exhibits high lifetime stability through a long heat treatment applied after the NTD in order to restore the desired crystal qualities.

This object is achieved according to the invention with a method for producing a neutron transmutation doped silicon single crystal comprising the features of the characterizing portion of claim 1.

The CZ silicon single crystal having such an interstitial oxygen concentration range as specified above has advantages that crystal defects induced by the NTD are annihilated by a heat treatment after irradiation effected at 1100°C for a predetermined period of time (30 - 360 min), without involving generation of new defects resulting in a reduction in the lifetime of the wafers. Thus, the intended resistivity and lifetime can be restored by the heat treatment after irradiation.

Many other objects and advantages of the invention will be apparent from the following detailed description with reference to the accompanying drawings.
FIG. 1 is a graph showing the change of the lifetime of the wafers caused by a restorative heat treatment effected under various conditions after the NTD in respect of a silicon single crystal with an interstitial oxygen concentration of 3.57 x 10¹⁷ cm⁻³;
FIG. 2 is a graph showing the change of the lifetime of the wafers caused by a restorative heat treatment effected under various conditions after the NTD in respect of a silicon single crystal with an interstitial oxygen concentration of 7.14 x 10¹⁷ cm⁻³;
FIG. 3 is a graph showing the change of the lifetime of the wafers caused by a restorative heat treatment effected under various conditions after the NTD in respect of a silicon single crystal with an interstitial oxygen concentration of 1.02 x 10¹⁸ cm⁻³;
FIG. 4 is a graph showing the change of resistivity caused by a restorative heat treatment effected under various conditions after the NTD in respect of a silicon single crystal with an interstitial oxygen concentration of 3.57 x 10¹⁷ cm⁻³;
FIG. 5 is a graph showing the change of resistivity caused by a restorative heat treatment effected under various conditions after the NTD in respect of a silicon single crystal with an interstitial oxygen concentration of 7.14 x 10¹⁷ cm⁻³;
FIG. 6 is a graph showing the change of resistivity caused by a restorative heat treatment effected under various conditions after the NTD in respect of a silicon single crystal with an interstitial oxygen concentration of 1.02 x 10¹⁸ cm⁻³;
FIG. 7 shows an X-ray topograph of a silicon wafer having a reduced lifetime;
FIG. 8 shows crystal defect observation photographs taken after preferential etching of wafers irradiated in the light water reactor and then heat treated at 1100°C for 360 min; and;
FIG. 9 shows crystal defect observation photographs taken after preferential etching of wafers irradiated in the heavy water reactor and then heat treated at 1100°C for 360 min.

According to the invention a CZ silicon single crystal is used for neutron transmutation doping achieved by irradiating the silicon single crystal with neutrons in a nuclear reactor such as a heavy water reactor or a light water reactor. The silicon single crystal has an interstitial oxygen concentration in the range not greater than 0.9 x 10¹⁸ cm⁻³ for irradiation in the heavy water reactor and not greater than 0.50 x 10¹⁸ cm⁻³ for irradiation in a light water reactor.

The interstitial oxygen concentration is calculated using an oxygen concentration conversion factor of 3.06 x 10¹⁷ cm⁻².

The CZ silicon single crystal having such an interstitial oxygen concentration range as specified above has advantages that by a heat treatment effected at 1100°C for a predetermined period of time (in the range of 30 - 360 min) after the NTD, the crystal defects induced by NTD are annihilated without involving generation of new defects causing a reduction in wafer lifetime, and the intended resistivity and lifetime can be restored.

The interstitial oxygen concentration range specified above is effective for both of the NTD performed in the heavy water reactor and the NTD in the light water reactor.

In the case of the NTD using the heavy water reactor, a CZ silicon single crystal having interstitial oxygen concentrations above 1.02 x 10¹⁸ cm⁻³ is not desirable because a restorative heat treatment of the neutron-irradiated CZ silicon single crystal results in generation of new crystal defects (precipitates in crystal) which will lower the lifetime. The same problem arises in case of the NTD using the light-water reactor if the interstitial oxygen concentration of the base CZ silicon single crystal exceeds 0.71 x 10¹⁸ cm⁻³. These two interstitial oxygen concentration upper limits were estimated from the experimental examples described below.

### [Examples]

### (1) Neutron Irradiation in the NTD

To silicon single crystals (200 mm length blocks) grown by the magnetic field applied Czochralski crystal growth (MCZ) method, the NTD was applied under the following conditions, using a light water reactor and a heavy water reactor.

### (2) Crystals Used in the NTD

Growth method: MCZ method
Diameter: 4 inches
Orientation: <111>
Type of conduction: p-type
Initial oxygen concentration: 3.57 x 10¹⁷ cm⁻³
   7.14 x 10¹⁷ cm⁻³
   1.02 x 10¹⁸ cm⁻³

### (3) Irradiation Condition 1: Light water reactor

Target resistivity: 40 - 50 Ωcm
Thermal neutron flux (average): 6.12 - 7.3 x 10¹⁷ n/cm²
Fast neutron flux (average): 0.62 - 1.46 x 10¹⁷ n/cm²
Irradiation time: about 8 hours

### (3) Irradiation Condition 2: Heavy water reactor

Target resistivity: 40 - 50 Ωcm
Thermal neutron flux (average): 5.76 - 7.76 x 10¹⁷ n/cm²
Fast neutron flux (average): 5.76 - 7.76 x 10¹⁷ n/cm²
Irradiation time: about 8 hours.

### (5) Heat Treatment Experiment

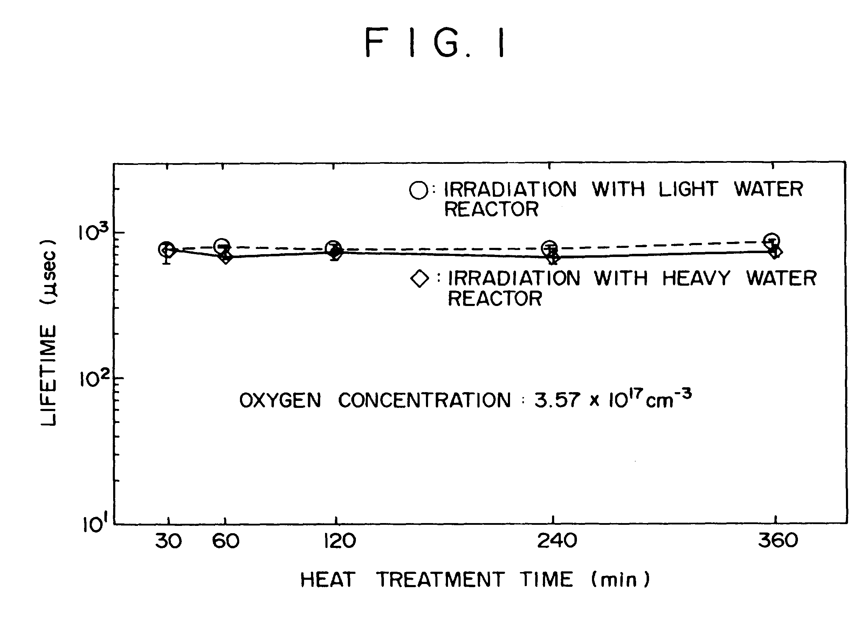

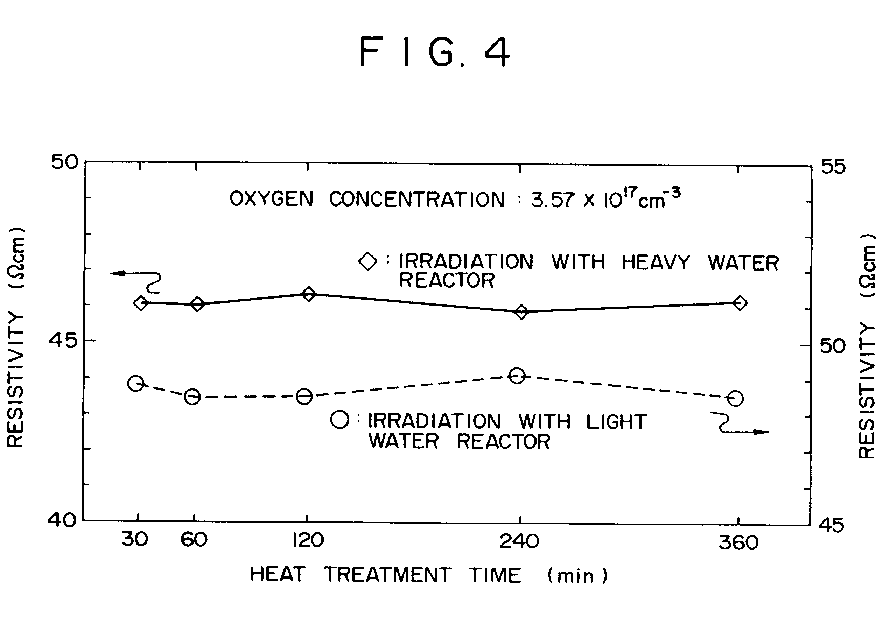

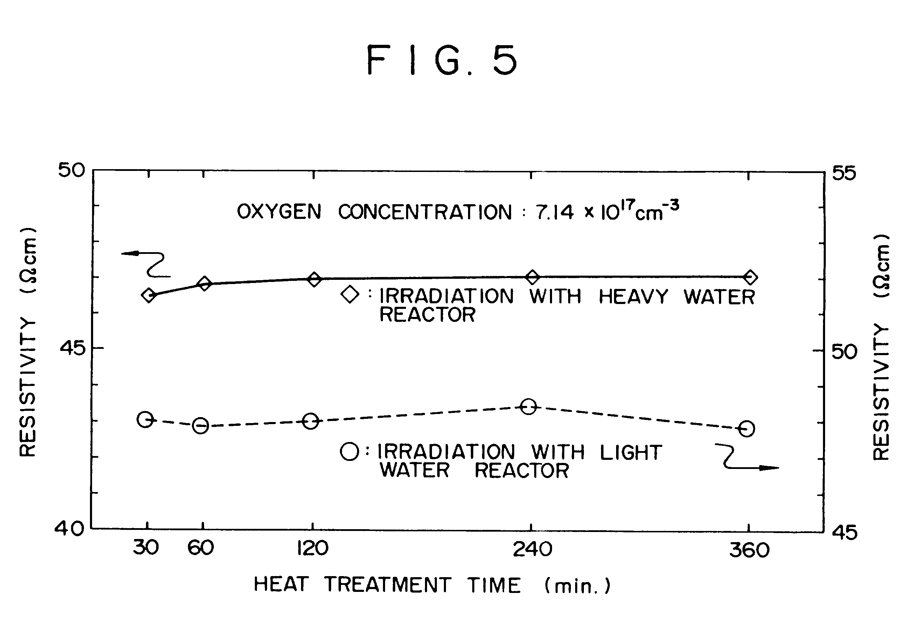

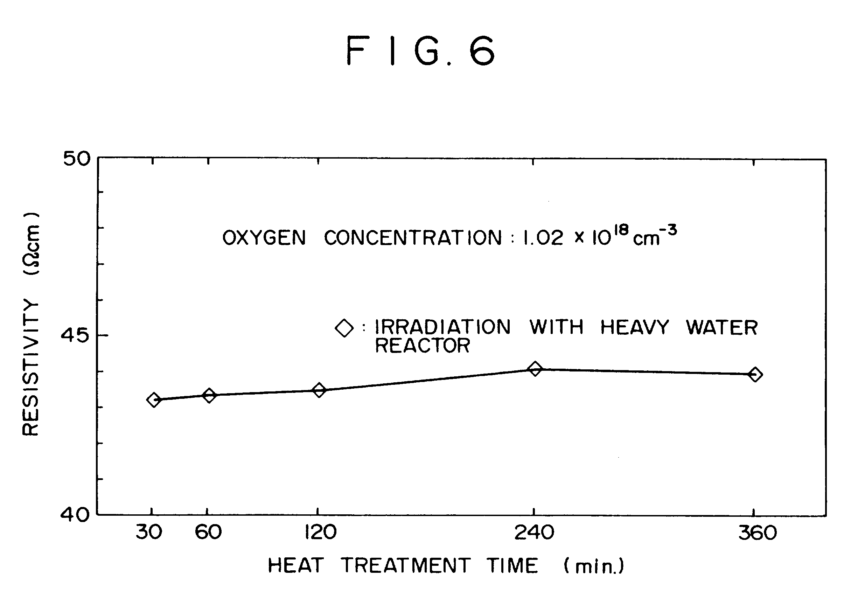

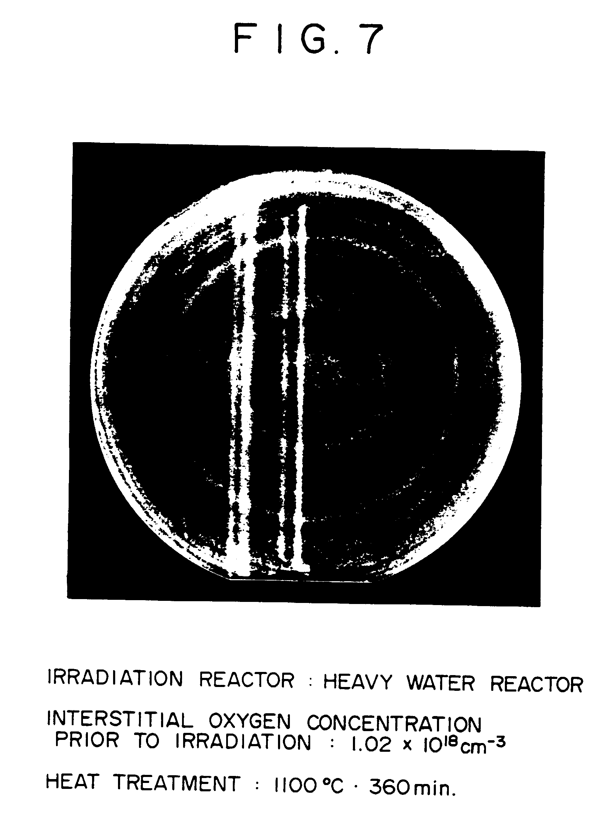

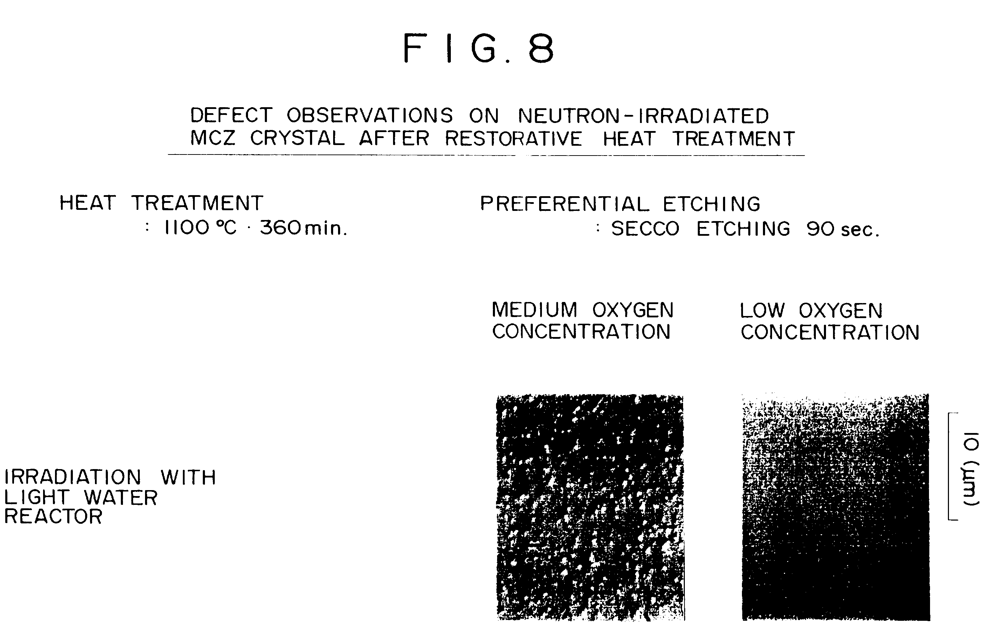

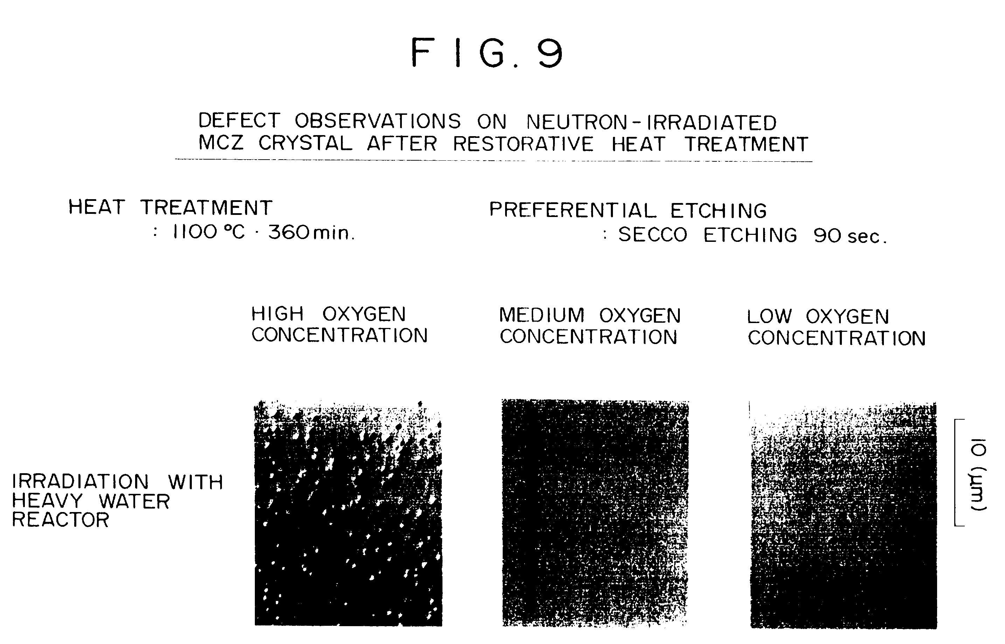

After irradiation in the light water reactor or in the heavy water reactor as specified above, individual MCZ silicon single crystals were sliced into wafers of 900 µm in thickness. Both groups of the wafers irradiated in the light water reactor and the wafers irradiated in the heavy water reactor were heat treated at a temperature of 1100°C. The heat treatment time was selected between 30, 60, 120, 240 and 360 min. The heat treated wafers were measured for wafer lifetime using a contactless microwave reflection type measuring system. The results obtained are shown in FIGS. 1 through 3. Using the four point probe method, the resistivity of the heat treated wafers was measured with the results shown in FIGS. 4 through 6. The heat treated wafers were also observed by an X-ray topography. The results obtained are shown in FIG. 7. Finally, the heat treated wafers were etched by the preferential etching for observation of crystal defects. The results obtained are shown in FIGS. 8 and 9.

As understood from FIG. 1, regarding the crystals having an interstitial oxygen concentration of 3.57 x 10¹⁷ cm⁻³, no reduction in lifetime can be observed throughout the time range 30 - 360 min of the heat treatment effected at 1100°C on both of the wafers irradiated in the light water reactor and the wafers irradiated in the heavy water reactor.

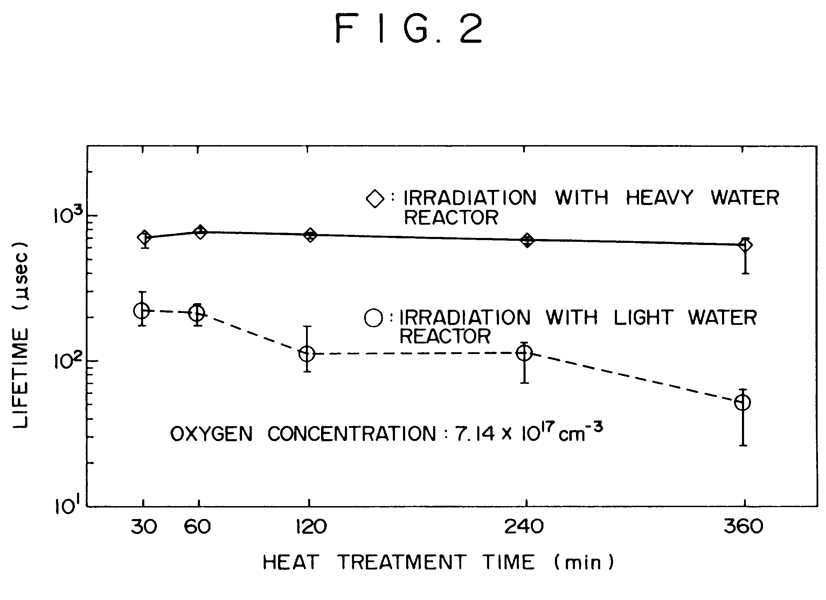

In the case of the start crystals having an interstitial oxygen concentration of 7.14 x 10¹⁷ cm⁻³, the lifetime of the wafers irradiated in the light water reactor decreases with the duration (30 - 360 min) of heat treatment effected at 1100°C, as shown in FIG. 2. Regarding the wafers irradiated in the heavy water reactor, no reduction in lifetime caused in conjunction with the heat treatment can be observed. This means that when the interstitial oxygen concentration as specified above is used, a restorative heat treatment effected at 1100°C on the wafers irradiated in the light water reactor is likely to develop new crystal defects which will lower the lifetime of the wafers.

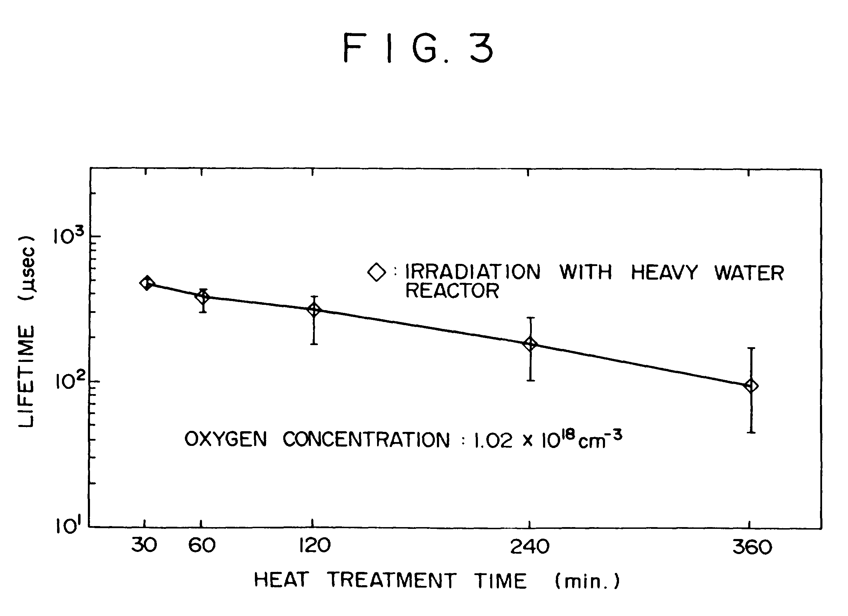

As is apparent from FIG. 3, when the interstitial oxygen concentration in the start crystal is 1.02 x 10¹⁸ cm⁻³, lifetime of the wafers irradiated in the heavy water reactor decreases with the duration (30 - 360 min) of the heat treatment at 1100°C. It may be estimated that in this interstitial oxygen concentration of the crystals, a restorative heat treatment effected at 1100°C on the crystal wafers irradiated in the heavy water reactor is liable to develop new defects causing a reduction in lifetime. No experimental results obtained in respect of the wafers irradiated in the light water reactor. However, as described in the preceding paragraph, the reduction of lifetime is already observed even at a lower interstitial oxygen concentration. Accordingly, it is obvious that in this interstitial oxygen concentration, the restorative heat treatment brings about a reduction in lifetime of the wafers irradiated in the light water reactor.

As shown in FIGS. 4 - 6, in each of the experimented interstitial oxygen concentrations, the resistivity of the wafers is substantially constant regardless of the change in heat treatment time. Therefore, it may be estimated that the resistivity recovery characteristic does not depend on the oxygen concentration.

After the heat treatment at 1100°C for 360 min, the wafers were put to a defect observation using the X-ray topography. From the wafers with which the reduction of lifetime had already been observed as described above, diffraction patterns were observed. The X-ray topograph of one such wafer is shown in FIG. 7 wherein the diffraction pattern is appearing as parallel straight light portions. It can be estimated from the X-ray topograph that the diffraction pattern is produced by precipitates developed by precipitation of oxygen in the wafer during the restorative heat treatment and, hence, the precipitation of oxygen is a main cause of the reduction of lifetime.

In order to prove the foregoing estimation, the same wafers as described above in the preceding paragraph were etched by the preferential etching for a purpose of defective observation. The results obtained are shown in FIGS. 8 and 9. From the observation, it was found that precipitates (resulting from precipitation of oxygen) were in fact developed in those wafers in which was observed the diffraction pattern estimated to be produced by the precipitates in each wafer.

From the experiments described above, we may conclude that for either type of the wafer irradiated in the light water reactor and the wafer irradiated in the heavy water reactor, the interstitial oxygen concentration of a crystal must be limited within a certain range in order to prevent a reduction in lifetime which would otherwise be caused when the irradiated wafer is heat treated at 1100°C in order to annihilate lattice defects induced by neutron irradiation in the reactor. The interstitial oxygen concentration has an upper limit which differs depending on the type of nuclear reactor used in the NTD. It has been experimentally proven that for use in NTD using the heavy water reactor, the interstitial oxygen concentration of the crystal is not greater than 0.90 x 10¹⁸ cm⁻³, while the upper limit of the interstitial oxygen concentration is 0.50 x 10¹⁸ cm⁻³ in the case of the NTD using the light water reactor.

As described above, a silicon single crystal used for neutron transmutation doping (NTD) has a specified range of interstitial oxygen concentrations, so that when it is subjected to a restorative heat treatment after neutron irradiation, crystal defects induced due to radiation damage can be annihilated without involving development of new defects leading to a reduction of wafer lifetime. Thus, the desired qualities of the crystal can be restored.

## Claims

1. A process for producing a neutron transmutation doped silicon single crystal grown by the Czochralski method, said process comprising the steps of:
forming a silicon single crystal using the Czochralski method;
irradiating said silicon single crystal with neutron particles from a neutron particle radiation source;
heat treating said silicon single crystal so as to anneal crystal defects in the silicon single crystal induced by said irradiation with neutron particles;
**characterized in that**
the interstitial oxygen concentration for the silicon single crystal to be formed using the Czochralski method is selected to be in the range of less than or equal to 0.9 x 10¹⁸ cm⁻³ in case a heavy water nuclear reactor is selected as said neutron particle radiation source; and
the interstitial oxygen concentration for the silicon single crystal to be formed using the Czochralski method is selected to be in the range of less than or equal to 0.5 x 10¹⁸ cm⁻³, in case a light water nuclear reactor is selected as said neutron particle radiation source.

2. A process for producing a neutron transmutation doped silicon single crystal as set forth in claim 3, wherein said step of heat treating the silicon single crystal so as to anneal crystal defects in the silicon single crystal includes the step of heat treating the silicon single crystal at 1100°C for a period of time in the range of 30-360 minutes.

## Revendications

1. Procédé pour produire un monocristal de silicium dopé par transmutation neutronique ayant poussé selon le procédé de Czochralski, ledit procédé comprenant les étapes de :
- formation d'un monocristal de silicium en utilisant le procédé de Czochralski ;
- irradiation dudit monocristal de silicium avec des particules neutroniques à partir d'une source de rayonnement de particules neutroniques ;
- traitement thermique dudit monocristal de silicium de façon à recuire dans le monocristal de silicium des défauts du cristal induits par ladite irradiation avec des particules neutroniques ;
caractérisé en ce que
- on choisi la concentration interstitielle en oxygène pour le monocristal de silicium se trouvant réalisé en utilisant le procédé de Czochralski inférieure ou égale à 0,9 x 10¹⁸ cm⁻³, dans le cas où l'on choisi pour ladite source de rayonnement de particules neutroniques un réacteur nucléaire à eau lourde ; et
- on choisi la concentration interstitielle en oxygène pour le monocristal de silicium se trouvant réalisé en utilisant le procédé de Czochralski inférieure ou égale à 0,5 x 10¹⁸ cm⁻³, dans le cas où l'on choisi pour ladite source de rayonnement de particules neutroniques un réacteur nucléaire à eau légère.

2. Procédé pour produire un monocristal de silicium dopé par transmutation neutronique selon la revendication 1, dans lequel ladite étape de traitement thermique du monocristal de silicium de façon à recuire des défauts du cristal dans le monocristal de silicium comprend l'étape de traitement thermique du monocristal de silicium à une température de 1100°C pendant un temps compris entre 30 et 360 minutes.

## Patentansprüche

1. Verfahren zur Herstellung eines neutronenumwandlungsdotierten Silizium-Einkristalls, der mit dem Czochralski-Verfahren gewachsen ist, wobei das Verfahren die folgenden Schritte umfaßt:
Bildung eines Silizium-Einkristalls unter Gebrauch des Czochralski-Verfahrens;
Bestrahlung des Silizium-Einkristalls mit Neutronen aus einer Neutronenstrahlungsquelle;
Wärmebehandlung des Silizium-Einkristalls, um die Kristalldefekte in dem Silizium-Einkristall auszuheilen, die durch die Bestrahlung mit Neutronen eingebracht worden sind;
**dadurch gekennzeichnet,** daß
die Sauerstoffkonzentration auf Zwischengitterplätzen für den Silizium-Einkristall, der unter Gebrauch des Czochralski-Verfahrens gebildet wird, so ausgewählt wird, daß sie im Bereich von weniger als oder gleich 0,9 x 10¹⁸ cm⁻³ ist, im Falle, daß ein Schwerwasserkernreaktor als Neutronenstrahlungsquelle ausgewählt wird; und
die Sauerstoffkonzentration auf Zwischengitterplätzen für den Silizium-Einkristall, der unter Gebrauch des Czochralski-Verfahrens gebildet wird, so ausgewählt wird, daß sie im Bereich von weniger als oder gleich 0,5 x 10¹⁸ cm⁻³ ist, im Falle, daß ein Leichtwasserkernreaktor als Neutronenstrahlungsquelle ausgewählt wird.

2. Ein Verfahren zur Herstellung eines neutronenumwandlungsdotierten Silizium-Einkristalls nach Anspruch 1, wobei der Schritt der Wärmebehandlung des Silizium-Einkristalls zur Ausheilung der Kristalldefekte in dem Silizium-Einkristall den Schritt der Wärmebehandlung des Silizium-Einkristall bei 1100°C über eine Zeitspanne im Bereich von 30 - 360 min umfaßt.
